Europäisches Patentamt

(19) European Patent Office

Office européen des brevets

(11) Publication number : **0 390 800 B1**

(12) **EUROPEAN PATENT SPECIFICATION**

(45) Date of publication of patent specification :
01.02.95 Bulletin 95/05

(51) Int. Cl.⁶ : **H03L 7/08, H03L 7/10**

(21) Application number : 88909711.9

(22) Date of filing : 17.11.88

(86) International application number :
PCT/AU88/00445

(87) International publication number :
WO 89/05063 01.06.89 Gazette 89/12

(54) INTEGRATABLE PHASE-LOCKED LOOP.

(30) Priority : 18.11.87 AU 5477/87
08.02.88 AU 6631/88
22.04.88 AU 7879/88

(43) Date of publication of application :
10.10.90 Bulletin 90/41

(45) Publication of the grant of the patent :
01.02.95 Bulletin 95/05

(84) Designated Contracting States :
AT BE CH DE FR GB IT LI LU NL SE

(56) References cited :
EP-A- 202 015
US-A- 3 805 183
US-A- 3 902 140
US-A- 4 392 113
US-A- 4 715 000
PATENT ABSTRACTS OF JAPAN, vol. 8, no.
107 (E-245)[1544], 19th May 1984; & JP-A-59 22
446 (MITSUBISHI DENKI K.K.) 04-02-1984
PATENT ABSTRACTS OF JAPAN, vol. 10, no.
95 (E-395)[2152], 12th April 1986; & JP-A-60 236
520 (HITACHI SEISAKUSHO K.K.) 25-11-1985

(56) References cited :
Patent Abstracts of Japan, E-127, page 150,
JP,A, 57-84625 (FUJITSU K.K) 27 May 1982
(27.05.82)
Patent Abstracts of Japan, E-136, Page 8,
JP,A, 57-111128 (FUJITSU K.K.) 10 July 1982
(10.07.82)
Patent Abstracts of Japan, E- 195, Page 44,
JP,A, 58-95430 (MASUSHITA DENKI SANGYO
K.K.) 7 June 1983 (07.06.83)
Patent Abstracts of Japan, E-57, page 130,
JP,A, 56-24828 (NIPPON DENKI K.K) 10 March
1981 (10.03.81)
Patent Abstracts of Japan, E-30, page 90,
JP,A, 55-99840 (NIPPON DENKI K.K.) 30 July
1980 (30.07.80)

(73) Proprietor : MAGELLAN CORPORATION
(AUSTRALIA) PTY. LTD.
38 McCoy Street
Myaree, Western Australia 6154 (AU)

(72) Inventor : BROOKS, David, Robert
1st Floor
184 St. Georges Terrace
Perth, W.A. 6000 (AU)

(74) Representative : Livsey, Gilbert Charlesworth
Norris et al
HYDE, HEIDE & O'DONNELL
10-12 Priests Bridge
London SW15 5JE (GB)

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### RELATED APPLICATIONS

The specification lodged in respect of this application is a cognate of the disclosures in Australian Provisional Patent Application No. PI 5477, entitled "Integratable Phase Locked Loop", filed 18th November, 1987, and Australian Provisional Patent Application No. PI 6631, entitled "Calibrator", filed 8th February, 1988, and Australian Provisional Patent Application No. PI 7879, entitled "A Modified Oscillator And Integratable Phase Locked Loop", filed 22nd April, 1988, all the aforementioned Applications having been lodged in the name of the present Applicant.

### FIELD OF INVENTION

The present invention relates to an integratable phase-locked loop (IPLL) for use in electrical or electronic circuit applications. More specifically, the present invention relates to a phase-locked loop (PLL) suitable for Very Large Scale Integration (VLSI implementation). Most specifically, the present invention relates to a substantially totally integratable PLL. The IPLL of the present invention has application in frequency synthesis and signal demodulation.

### PRIOR ART

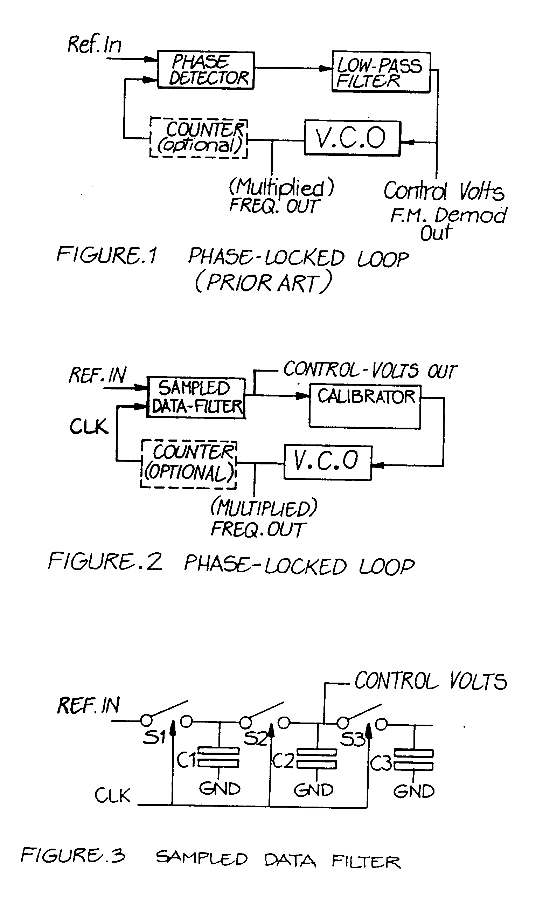

A prior art Phase Locked Loop (PLL) comprises at least three elements; a Voltage (or Current) Controlled Oscillator (VCO), a Phase Detector or Comparator (PD), and a Low Pass Filter (LPF). These elements are connected in a ring formation, whereby the PD measures the difference in phase between an external Reference signal and the VCO's output, and this difference filtered by the LPF serves to adjust the frequency of the VCO, so as to keep it in synchronism with the Reference signal. Optionally, a Frequency Divider may be connected at the output of the VCO, which then runs at a multiple of the Reference frequency, and the entire PLL constitutes a frequency multiplier. This type of circuit is described, inter alia, in "Phase-Locked Loops: Theory, Design & Applications", Best R. E., McGraw Hill 1984. Figure 1 shows a prior art PLL.

Other prior art PLL circuits are exemplified by 'Hochschild" in US 4,538,282, "Klinkovsky, Severin" in US 4,571,731, and "Fried" in US 4,626,798.

US 3 805 183 is described in terms of discrete components, and certain of its components (eg certain capacitors, an inductor, and the oscillator, which may be a YIG oscillator) are not integrable.

A development of the basic phase locked loop system has been described in US 3,805,183 (Lance/California Microwave Inc). In this, signal processing means are interposed between the output of a sampling phase detector and the control input of the VCO, the signal processing means including two parallel paths. The first path included frequency-sensitive filters (an LC filter and an RC filter), which determine normal loop-bandwidth characteristics for the system to achieve desired response characteristics to changes in the reference signal. The second path is biased to be normally non-conductive but to conduct in the event of high loop stress. This increases the loop bandwidth and hence the control capability of the loop until the control signal returns to the normal narrow range; when this condition is reached, the second path becomes non-conductive and the system automatically reverts to its normal condition.

Prior art PLL's known to Applicant do not in fact achieve the goal of total integration, in that they integrate many but not all components on the VLSI chip.

US 4,626,798 discloses a PLL which achieves total integration, but it is only suitable for use at extremely high frequencies (quoted as above 100MHz). Not only are lower frequencies more commonly required, but very high frequencies require specialised circuit techniques, for example Emitter-Coupled Logic, which is both costly to produce and consumes large amounts of electrical power in use. At the high frequencies disclosed in US 4,626,798, use is made of the resistance of the ordinary circuit wiring to form the LPF, (page 5, lines 45 to 50). This is not available at lower frequencies, where the values required for such resistors become excessive. Further, the electrical value of such wiring resistance is poorly controlled in most practical VLSI fabrication processes, which can lead to poor control of the LPF characteristics. This may lead to unpredictable behaviour in the presence of changes (e.g. modulation) in the Reference input signal. A mathematical analysis in the book by "Best" referred to above shows that even small changes in the LPF characteristics may, in some cases, prevent the PLL from ever acquiring lock, or require an excessive time to acquire lock.

The disadvantages of very high frequency operation, as noted above, will equally apply where a moderate-frequency PLL is to be realised by building a very high frequency PLL, and passing the output through a frequency divider to achieve a moderate frequency output.

US 4,538,282 discloses a PLL which utilises the so-called "digital VCO" concept, whereby the adjustable frequency from the VCO is obtained by passing a constant, high-frequency input through a variable frequency-divider circuit. The output frequency is then the original high frequency divided by the modulus of the divider circuit.

Such a system suffers from two potential drawbacks, namely that a separate high-frequency clock source is necessary and that the output frequency will never (except fortuitously) be exactly correct, since the divider modulus is constrained to be a numerical integer. Hence the output frequency typically hovers above and below the desired value. For many applications (e.g. data recovery in communications systems) this inaccuracy can be tolerated. However, if the PLL output is intended (for example) to serve as the carrier frequency for a radio transmitter, a pure frequency is required.

Other prior art PLL circuits have required additional external components to control the operating frequency of the VCO and/or to determine the operation of the LPF. Known PD circuits (suited to VLSI implementation) have been fabricated from various arrangements of digital logic gates, and are described in the book by "Best" referred to above. Such circuits generate an output, representing the analogue phase error, as a pulse-width modulated (PWM) digital waveform, which is converted to an analogue voltage by the integrating action of the LPF. As the loop approaches correct lock, this error reduces towards zero, represented in the PWM signal by a train of increasingly narrow pulses. It can be shown mathematically (by use of standard Fourier transforms) that such pulse-trains are equivalent to a set of sinusoidal waveforms, containing increasing amounts of energy at higher and higher frequencies, as the pulses become narrower. The required LPF circuit is commonly fabricated from resistors and capacitors external to the VLSI chip since, at low and moderate frequencies, these components require values too large for practical VLSI implementation.

An alternative form of LPF, suited to VLSI implementation, is the so-called Switched-Capacitor Filter (SCF). This type of circuit is described in such texts as 'Switched Capacitor Circuits' (Allen & Sanchez-Sinencio, van Nostrandt 1984). Such circuits have, however, an inherent limit on the maximum signal frequency they can process. This limit is described by the 'Nyquist Sampling Theorem', which states that such circuits cannot process signals containing energy components at frequencies above one-half of the frequency at which the filter is itself clocked.

The foregoing discussion demonstrates that the logic-gate type of PD, and the SCF, are mutually incompatible since, as exact synchronism is approached, the logic-gate PD generates increasingly narrower output pulses and hence increasing output energy at progressively higher frequencies. Eventually, such frequencies will exceed the "Nyquist Limit" (as described above) of the SCF, and the output from said SCF will no longer correctly represent the input signal. The practical result is that such a PLL develops an output which "hunts" about the correct frequency, in a similar manner to the "digital VCO" concept described above.

The solution generally adopted in prior art PLL products (e.g. the Motorola MC4046 integrated PLL, and others) has been to retain the logic-gate PD, and to fabricate the LPF from discrete components, external to the chip, as described. This of course defeats the goal of integration, or at least total integration.

A further use of external components, in prior art PLL designs, has been in the VCO circuit. The reason for their use here, is that passive components (resistors and capacitors) fabricated on VLSI chips, are subject to very wide manufacturing tolerances (up to 4 to 1). [These wide tolerances are a further reason why conventional resistor/capacitor LPF circuits are unsuitable for VLSI implementation, necessitating SCF circuits.] This translates into a wide spread in the VCO's characteristics, which greatly adds to the difficulties of PLL circuit design. By contrast, discrete components with tolerances as low as 1% are readily available from normal commercial sources. These external components (including the processes of attaching them to the circuit) can greatly add to the cost of a completed product and substantially limit product miniaturisation.

A SCF may be employed to act both as PD and LPF, in phase-sensitive circuit designs. The elements of a PLL according to this principle are disclosed in "Allen & Sanchez-Sinencio" referred to above, who do not however, disclose the realisation of such a circuit. In particular, the simple two-capacitor SCF shown therein, is inadequate for use in many practical PLL designs.

This simple type of PLL is unsuitable for a fully-integrated embodiment, due to the manufacturing tolerances aforesaid. These will result in a large spread in the initial VCO frequency (when the reference input is first applied). Should this frequency deviate too far from the correct value, a "false lock' condition may result. One such situation may cause the SCF, which may be clocked by the VCO, to sample non-adjacent cycles of the input signal. In such a case, the SCF will still "see" a steady DC value, and the PLL will reach a stable operating point with the VCO running at one-half its intended frequency. In practice, there are many more such "false lock" situations, which must be carefully avoided. The presence of these "false locks" has detracted from the usefulness of this PLL configuration in prior art.

OBJECTS OF THE INVENTION

An object of the present invention is to provide a PLL circuit which alleviates some or all the disadvantages of the prior art.

More specifically, the object of the invention is to provide an integratable PLL circuit in which the dangers of the "false lock" problems discussed above are alleviated or overcome.

Accordingly, the present invention provides an integrable phase locked loop (IPLL) circuit comprising: sampled data filter means which sample a reference signal to provide a control signal at its output; and voltage or current controlled oscillator means (VCO) having a control input to which the output of the filter means is fed, the oscillation frequency being regulated by the control signal, and which provide an output digital signal which is fed back to the filter means to provide a clock signal for the sampling; characterized by calibrator means coupling the output of the filter means to the control input of the VCO and including adjustable gain and/or bias means settable to determine the overall control-signal-to-frequency characteristic of the IPLL irrespective of the control-signal-to-frequency parameter of the VCO.

The IPLL may be substantially totally integratable.

The present invention may provide a frequency divider or counter arranged to inter-couple the input of the sampled-data filter and the output of the VCO. The divider may be programmable or predetermined such that the IPLL of the present invention serves to function as a frequency multiplier.

The present invention thus provides a calibrator arranged to inter-couple the sampled-data filter output and VCO input. The calibrator allows the IPLL characteristic to be adjusted or set to a particular desired value to compensate for wide manufacturing tolerances, or to be settable to any desired value within some range, or both.

The IPLL of the present invention may include any known VCO and/or sampled-data filter. The type of VCO and/or filter used may be determined by the particular VLSI implementation or IPLL application. The sampled-data filter may comprise any known SCF and integrator.

Preferred embodiments of the present invention will now be herein described with reference to the accompanying drawings, wherein:

Figure 1 shows a prior art PLL arrangement.

Figure 2 shows an IPLL according to the present invention.

Figure 3 shows a preferred form (only) of sampling filter.

Figure 4 shows a preferred form (only) of VCO.

Figure 5 shows a calibrator in block diagram form.

Figure 6 shows a preferred form (only) of calibration arrangement.

Figure 7 shows an alternative preferred form of calibration.

Figure 8 shows the timing of operations for the calibration function of a discrete component test circuit of the present invention.

Figure 9 shows a Voltage to Current Converter, according to prior art.

The IPLL is capable of fabrication on conventional MOS (Metal-Oxide-Semiconductor) silicon "chips", requiring no special processes or methods, at minimum cost.

The IPLL is inherently tolerant to the wide variations in component values which commonly occur in VLSI "chip" manufacture due to manufacturing tolerances. This minimises manufacturing cost.

The IPLL allows the characteristics both of the VCO and the LPF to be closely controlled, so providing highly predictable PLL characteristics.

The IPLL is capable of generating a substantially spectrally pure output, that is, whose output frequency is substantially constant, rather than hovering about a "correct" value.

The present invention utilizes the ability of a SCF circuit to perform the duties of a PD in addition to its primary filtering function. The use of a SCF in this mode may be understood when it is recalled that the SCF, like all other sampled-data circuits, operates by taking a "snapshot" of its input signal at regular instants in time, and then processing these "snapshots". If such regular "snapshots" are taken of an object describing some form of periodic motion (e.g. rotation), a situation arises similar to that of the well-known stroboscope, or automotive engine timing-light. If the samples ("snapshots") are taken at a rate equal to that of the object's periodic motion, the object may appear stationary, since the object is in the same position when each sample is taken. Further, if said input signal is of a substantially continuous form (e.g. sinusoidal or triangular, but not rectangular pulses), any variation in the instant of sampling will manifest as a change in the "apparent" DC voltage seen by the SCF. The device therefore exhibits a phase-sensitive characteristic.

The electrical analogy of this is a periodically varying electrical signal, which is then sampled at regular intervals. Since such regular sampling is a characteristic of the SCF's normal operation, it is apparent that such action will occur when an input signal, varying at the same rate as the SCF is itself being clocked, is applied to the SCF. The SCF effectively samples the same instant on successive cycles of the input waveform, and will therefore "see" a constant DC voltage at its input. Further, if said input signal is of a substantially continuous form (e.g. sinusoidal or triangular, but not rectangular pulses), any variation in the instant of sampling will manifest as a change in the "apparent" DC voltage seen by the SCF. The device therefore exhibits a phase-sensitive characteristic.

The IPLL of the present invention includes a sampled-data filter, or a filter which operates in a strobic manner. The sampled-data filter operates to stroboscopically see, an input signal; i.e. the filter samples the input signal at points in time determined by a clock signal. If the frequency of (clock) sampling is substantially equal to the frequency of the input signal, the filter will "see" a DC signal.

An Integratable Phase Detector (PD)

In a SCF, a "resistor" may be simulated by a capacitor interjacent between two (transistor) switches.

Such a "resistor" when coupled with an additional capacitor provides a simple LPF. The characteristics of such a SCF depend on the ratio of size of capacitors used rather than their actual capacitive value. The frequency at which the (transistor) switches are cycled is also of importance to the SCF characteristics. As shown in Figure 3, S1, S2 and C1 provide a "resistor" and in conjunction with C3, provide an LPF, as aforementioned. The additional capacitor and switch (C2 & S3) provide a phase-advance characteristic in the SCF, such phase-advance serving to improve the damping of the complete PLL, causing it to acquire lock (upon application of a suitable reference signal) more rapidly. A control voltage output can be taken from C2, rather than (in accordance with usual SCF practice) from the end of the chain, at C3. The sampling of the input signal is accomplished via any one of or all switches S1, S2, S3. (Preferably S1, S3 are operated substantially in unison, but in opposition to S2. Further, the switches should preferably be so controlled, that at no time are all three closed simultaneously).

With reference to Figures 2 and 3, the input to the IPLL can be a signal of a continuous form, i.e. an analog signal. If the input signal has a frequency substantially equal to the SCF clock frequency, the filter may see, a substantially constant DC voltage (by a process similar to that of an optical stroboscope, as hereinbefore described). The DC voltage seen may depend upon the point(s) in time at which the input signal is sampled. In this way, an SCF may form an ideal sampled-data filter.

The output of the filter (control volts), provides an input signal, or controlling signal, for the VCO of the IPLL. The output signal or oscillation of the VCO can be used to provide the CLK signal for the SCF which enables sampling in the sampled-data filter.

In order to alleviate the above-mentioned 'false lock' problem, the PLL is arranged to enter a "set-up" mode when a new reference signal is applied. In this mode, the LPF output is forced to a specific value, and the VCO frequency is brought approximately to some predetermined value, by a coarse adjustment, as more fully described below. One or more such adjustments may be performed before the PLL is enabled to seek final lock. This method is especially effective in cases where the PLL is required to function as a frequency multiplier, since the frequency divider may be utilised to perform the coarse-lock function.

Any suitable form of counter or divider may optionally be fed by the VCO output in order to provide the sampled-data filter with a reduced clock frequency. The IPLL can then function as a frequency multiplier, the multiplied frequency output being proportional to the division provided by the counter. The PLL of Figure 2 includes such an (optional) counter.

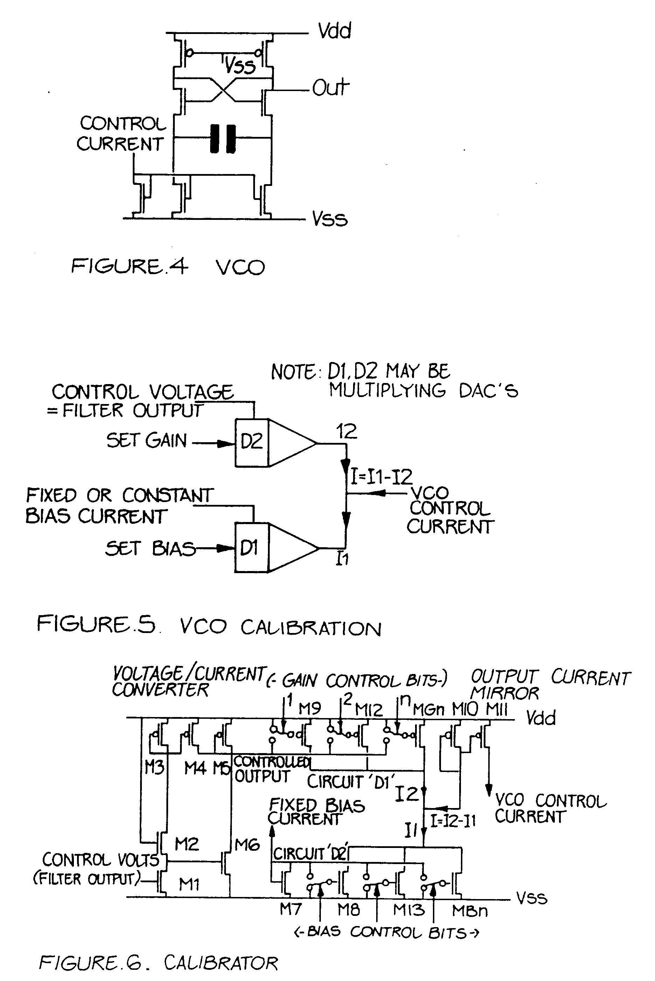

A known form of VCO is shown in Figure 4, being a Source-Coupled Multivibrator. (Note that, following usual practice, the circuit is still referred to as a VCO [Voltage-Controlled Oscillator), notwithstanding it is in fact, current controlled. The term Current-Controlled Oscillator is not often used.)

A calibrator is provided with the IPLL as shown in Figure 2. The calibrator serves to alleviate 'false lock'. The following describes two preferred methods and preferred apparatus of the calibrator.

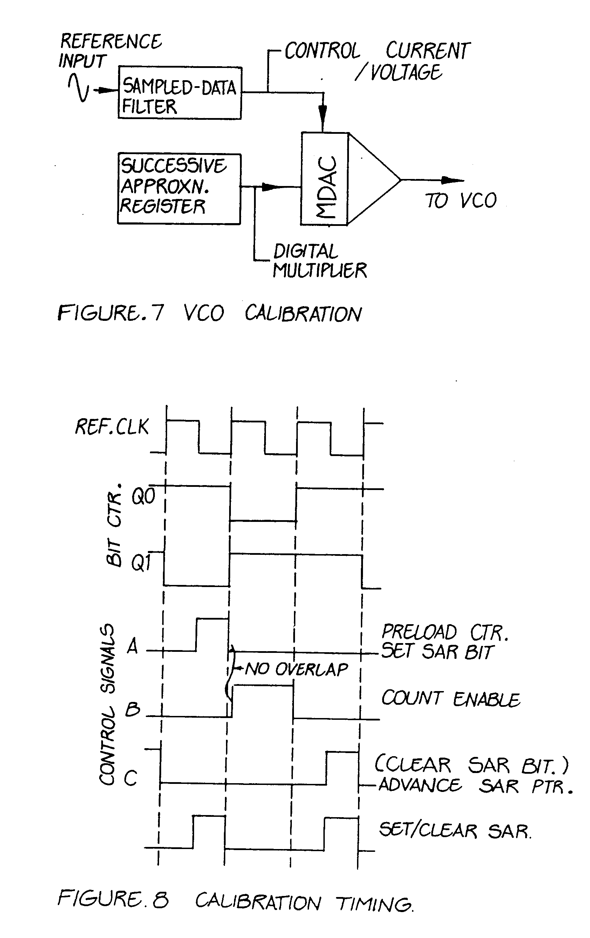

Calibrator: First Embodiment (See Figures 5 and 6)

The underlying principle of the VCO calibration process may be found in Analytical Geometry. The objective is to define the characteristic (i.e. the graph of output Frequency versus Control Voltage/Current) of the VCO. Without calibration, this characteristic may be subject to very wide manufacturing tolerances, as noted above.

Given that the characteristic of the VCO approximates somewhat a straight line (at least over the span of practical interest), it is sufficient to determine two points on that line, for the entire line to be determined. The calibrator operates by determining two such points, near the lowest and highest frequencies at which the VCO is required to operate.

The calibrator may adjust the performance of a Voltage (or current) Controlled oscillator, and may compensate for manufacturing tolerances in circuit parameters. This can be advantageous in an IPLL due to possible wide production spreads of VLSI characteristics. Wide production spreads may result in a wide variation in sensitivity of the VCO circuit (its frequency, as a function of the controlling voltage/current). This can reduce the IPLL's accuracy or cause "false locking" as described above.

The principle is that the control voltage is processed by a calibrating stage before being applied to the VCO circuit. This calibrator may have one or two programmable or setable parameters; its gain and/or its bias or offset, which may be added to the output value. The transfer function of the circuit may be :

$$\text{Equation 1 : Vo = Bias + Vin x Gain}$$
$$\text{where Vo = output; Vin = Input.}$$

The calibration process assigns value(s) to the gain and/or the bias. This can preferably be done by providing any form of known sequential logic controller (such as a State Machine, or a Microprogrammed Controller), which executes a calibration procedure at start-up. In practical designs, such a sequential controller may also be needed for other purposes, and the calibration function may conveniently be assigned to existing circuitry, by the addition of some extra "programming". (For convenience, the process of determining the operating algorithms of the controller will be described as "programming", without prejudice as to the actual controller implementation i.e. the programming may be accomplished via hardware, firmware or software or a combination thereof).

The calibration circuitry provides means to override the output of the filter, and force the filter's output signal to either a minimum or a maximum value. The gain and bias inputs may be conveniently provided as digital signals or data sourced from a counter or register under the control of a sequential controller or may be provided via other convenient means.

A counter means (frequency counter FC) can also be provided as an option, which may be clocked by the VCO output, and which may be examined by the sequential controller, and may alter the "program's" flow of control and/or be utilised as data by such program. When the IPLL is used as a frequency multiplier, the FC may conveniently be the prescaling divider hereinbefore described.

The sequential controller may be clocked (at least, during the calibration process) from the IPLL's "reference" input signal, (see Figure 2) which is assumed to be of known frequency. Alternatively, another clock source of known frequency may be provided. Hence the time required to execute each "instruction" of the controller, is known.

Given the general calibrator and method outline described above, the calibration procedure may be as follows (implemented by commands from the sequential controller).

The minimum frequency can be set by inducing the filter's output to a LOW condition, approximately to zero volts. Hence, using equation 1, the output of the calibrator may simply be the value of the bias input. The bias input can be derived from a counter or similar device, directed by the controller. The controller may preload this counter or register means, with either a minimum or maximum value, as required. It may then preset the FC, and permit the VCO to increment the FC for a known number of controller "instruction" times (hence a known period). The count remaining in the FC after this time can then be tested by the controller, which then determines whether the VCO output frequency is above or below a set point.

If, for example, we commenced by loading zero into the bias control bit register, we can expect the VCO frequency to be low. While the frequency is low, we may proceed to increment the bias register, and repeat the aforementioned FC count test. When the set point is reached the VCO lower limit has been set. If we elected to initialise the bias register to a maximum value, we may expect an initially high VCO frequency, and can reduce the bias value until the set point is reached.

An alternative, faster, method of setting the register bits, is the "successive approximation" method commonly used in Analogue-to-Digital Converters. The process begins by setting all register bits to zero (assumed to represent minimum VCO frequency). The most significant register bit is then set to one, and the VCO frequency is tested as described above. If the frequency is found to be too high, the register bit is reset to zero. The next lower significance register bit is then set to one, and the process repeats until all bits have been set or reset as is required.

The maximum frequency setting may be similar to the minimum frequency setting but the previously set bias value can be retained and the filter output can be forced to a maximum value. A similar process to that described above can adjust the gain, to set the VCO's intended maximum frequency.

Having set one or two operation limits of the VCO's control span for a particular application of the IPLL, the VCO's sensitivity may be determinable, since it is known to be substantially linear, and two points on that line (in frequency and voltage) have just been determined. We may now enable the filter output, and allow the PLL to seek final lock.

A preferred embodiment of calibrator is shown in Figures 5 and 6 of the accompanying drawings. The drawings show the operation of the controlled buffer stage only: the design of digital circuits (Sequential Controllers, Counters, etc.) is well known: details are available in many standard texts (such as Introduction to VLSI Systems, Mead & Conway, Addison-Wesley 1980). The illustrated embodiment assumes a CMOS fabrication process, however other MOS processes (for example NMOS or PMOS) could also be used.

The embodiment predominantly makes use of the so-called "current mirror" circuit. This is a well-known device, for developing multiple current sources (or sinks), as accurately known multiples of a given input current. Familiarity with this standard circuit is assumed.

With reference to Figure 5, the calibrator is implemented as two, Digital-to-Analogue Converters (DAC). These circuits have the property of generating an output current, which is proportional to a digital input value. D1 is a simple DAC of this type. D1 in practice may comprise a "multiplying DAC", having one input fixed. D2 may be a "multiplying DAC", in which the output current is proportional to the product of the digital input as aforesaid, and of an additional (analogue) input.

The filter of Figure 2 may generate a voltage output, and therefore a Voltage-to-Current conversion function is required to drive the DAC'S. In the circuit of Figure 6, the current through M5 is inversely proportional to the voltage input at M1, for values between the transistor threshold voltage $V_{te}$, and $V_{dd}/2$. Because of this inverse relationship, the output of the two DAC's can be subtracted rather than added. In Figure 6, the controlled output signal can feed the gates of further transistors, having a current mirror arrangement, replicating in proportion the current through M5. This circuit is embodied within the Multiplying DAC, D2.

A preferred form of DAC is shown in part of Figure 6. Transistors M9, M12, MGn provide gain values and represent the first, second, nth gain control bit respectovely. M8, M13, MBn provide bias values and represent the first, second, nth bias control bit respectively. There are as many transistors as there are bits required. The more bits, the more the precision setting or adjustability, however, calibration time is proportional to the number of bits. Practically, three or four bits provides sufficient accuracy and adjustability. The illustration of Figure 6 provides 3 bits of control, as an example only.

The significance of a bit may depend on the width/length ratio of the transistors. For example, if M13 is twice the size of M8, the M13 bit has twice the significance of the M8 bit, and so on. The same may apply for the gain control. Assuming M7 is of substantially the same width as M8, and each succeeding transistor is twice the width of its predecessor then, I1 = fixed bias current x binary weighted value of bias control bits.

Considering the D2 circuit, in Figure 6, transistor M9 may form the second half of a current mirror, when its gate is fed from bias out (M5). Hence the current I2 is multiple of current through M5 (the multiple being as the size ratio of M5 and M9). As aforementioned, there may be multiple M9 switch/transistor pairs, controlled by the several bits of the gain input. Hence, the current I2 may be proportional to the current through M5, multiplied by the binary weighted value of the gain bits. This constitutes a multiplying DAC, whose output is inversely proportional to the control voltage (Vin). Vin can be the sampling filter output (optionally forced low or high, as described above).

The other DAC, D1, may be formed by M8, M13, MBn transistor array and may operate substantially identically, except that its input control current has a fixed value. The current 11 hence is proportional to the binary bias value. The difference I1-I2 can be taken, and fed via the current mirror M10/M11, to the VCO input as an oscillation frequency controlling current.

Because of the inverse relationship at D2, the calibration process outlined above may be modified slightly. It may be assumed that the VCO has a direct, not inverse, current/frequency control characteristic. Vin may be forced to a maximum and because of this inverse characteristic of the D2 voltage/current converter circuit, the bias out signal may reduce to zero. Hence, I2 is almost zero.

Adjusting the bias, as described above, adjusts I1 to bring the VCO to its maximum frequency. If bias is held constant, Vin may be set to zero and brings I2 to a maximum value having regard to the current value of the gain input. This reduces the value I1-I2, and the VCO output can then fall. Adjusting the gain can now bring the VCO to a correct minimum frequency i.e. setting I2. The VCO is now substantially calibrated and the IPLL can now be activated and allowed to "lock".

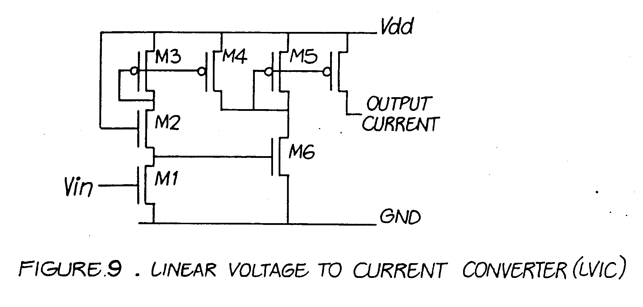

## Calibrator: Second Embodiment (See Figures 7 to 9)

The calibrator hereinafter described generally requires less circuitry than that of the first embodiment, but it does require a VCO circuit having an inherently linear control characteristic, essentially down to approximately zero frequency. The multivibrator circuit aforementioned for example, exhibits this property, as do many others which are also known. Given this, the first calibration point is implicitly provided at the zero current/frequency point, requiring only a single calibration step, to set the characteristic. In effect, the characteristic is allowed to pivot about the zero "point" until it intersects the required calibration point. Conveniently, this (single) calibration point will be located as close as possible to the final (i.e. in-lock) intended VCO frequency. This is accomplished quite simply, in the following manner:

The control voltage (from the filter) is multiplied by a constant, before being applied to the VCO. This constant is adjusted during the self-calibration process. The use of a multiplicative, rather than additive, adjustment serves also to stabilise the VCO's sensitivity function (i.e. the slope of its response). A variation of this second embodiment is also possible, wherein instead of multiplying the control voltage (or current) by an adjustable factor, the timing capacitor(s) in the VCO circuit itself is similarly adjusted. Since the VCO frequency is determined by the combination of the control current and the timing capacitance, the effect is the same. In the VCO of Figure 4, this might be done by replacing the single capacitor shown, by a plurality of capacitors each in series with a suitable (transistor) switch, such capacitor/switch pairs being connected in parallel, in place of the original capacitor. If these plurality of capacitors are of suitably varied sizes, the associated switches may be operated in a manner similar to that aforesaid. A prototype discrete component form of the PLL according to the present invention was made from conventional (discrete) components in order to test the aforementioned described circuit. The majority of the circuit was built from bipolar TTL components, with CMOS used for the analogue switches (used in the SCF circuits), and their drivers. The operation of the self-calibrator is similar to that of a successive-approximation analogue to digital converter. It accepts a reference signal AC-IN, at 132kHz sinusoidal, 10V peak to peak. The 132kHz logic clock, REF, is developed from this, by the sine to square waveform converter. The prototype PLL acquired lock (after completion of the calibration function) in under 300micro-seconds, over a reference frequency range of 115 - 150kHz (the design frequency is 132kHz). With-only 5 bits active, the acquisition range reduced to 123 - 148kHz.

Sinusoidal FM was recovered from 50 - 2500Hz, for Reference input frequency deviations of ±450 to ±2000 Hz. Improved performance is anticipated in the contemplated embodiment of the present invention i.e. fully integrated PLL. A substantially MOS process is contemplated for the IPLL.

## Claims

1. An integrable phase looked loop (IPLL) circuit comprising:
   sampled data filter means which sample a reference signal to provide a control signal at its output; and
   voltage or current controlled oscillator means (VCO) having a control input to which the output of the filter means is fed, the oscillation frequency being regulated by the control signal, and which provide an output digital signal which is fed back to the filter means to provide a clock signal for the sampling;
   characterized by calibrator means coupling the output of the filter means to the control input of the VCO and including adjustable gain and/or bias means settable to determine the overall control-signal-to-frequency characteristic of the IPLL irrespective of the control-signal-to-frequency parameter of the VCO.

2. An IPLL as claimed in Claim 1, wherein the filter means stroboscopically samples the reference signal.

3. An IPLL as claimed in Claim 1 or 2 being substantially totally integratable.

4. An IPLL as claimed in Claim 1 or 2, being fabricated using substantially MOS technology.

5. An IPLL as claimed in Claim 1, wherein the filter means includes a switched capacitor filter (SCF) and an integrator means.

6. An IPLL as claimed in Claim 1, wherein the calibrator means includes at least one digital to analogue converter (M9-M12-MGn, M7-M8-M13-MBn; MDAC) and further wherein the characteristic of the VCO is determined over the range operating frequencies of the IPLL.

7. An IPLL as claimed in any one of claims 1 to 6, wherein the calibrator means includes a digital to analogue converter (M9-M12-MGn) adapted to set the slope or gain of the calibrator.

8. An IPLL as claimed in any one of claims 1 to 7, wherein the calibrator means includes a digital to analog converter (M7-M8-M13-MBn) adapted to set the bias of the calibrator.

9. An IPLL as claimed in Claim 6 or 7, wherein the calibrator means further includes a register adapted to multiply the second reference signal by a constant.

10. An IPLL as claimed in Claim 1, wherein capacitor/switch pairs are provided in association with the VCO in order to influence the characteristic of the VCO.

11. An IPLL as claimed in Claim 1, further comprising counter or divider means (COUNTER) adapted to receive the digital signal and provide to the filter means a divided or multiplied clock signal, the IPLL providing a multiplied frequency output from the VCO.

12. An IPLL as claimed in Claim 1, being adapted for operation at low or moderate frequencies.

13. An IPLL as claimed in Claim 1, wherein the output signal is substantially spectrally pure and therefore a single frequency.

## Patentansprüche

1. Integrierbarer Phasenregelkreis (IPLL), bestehend aus Abtastdaten-Filtereinrichtungen,
   die ein Bezugssignal abtasten, um an ihrem Ausgang ein Steuersignal abzugeben, und
   spannungs- oder stromgesteuerten Oszillatoreinrichtungen (VCO) mit einem Steuereingang, denen das Ausgangssignal der Filtereinrichtungen zugeführt wird, wobei die Schwingungsfrequenz vom Steuersignal reguliert wird, und die ein digitales Ausgangssignal erzeugen, das zu den Filtereinrichtungen rückgekoppelt wird, um ein Taktsignal für die Abtastung zu erzeugen,
   **gekennzeichnet durch**,
   Eicheinrichtungen, die den Ausgang der Filtereinrichtungen mit dem Steuereingang der VCO koppeln und einstellbare Verstärkungs- und/oder Vorspannungseinrichtungen enthalten, die einstellbar sind, um die Gesamt-Steuersignal/Frequenzcharakteristik des IPLL unabhängig von dem Steuersignalfrequenzparameter der VCO zu bestimmen.

2. IPLL nach Anspruch 1,
   **dadurch gekennzeichnet**, daß die Filtereinrichtung das Bezugssignal stroboskopisch abtastet.

3. IPLL nach Anspruch 1 oder 2,
   **dadurch gekennzeichnet**, daß er im wesentlichen vollständig integrierbar ist.

4. IPPL nach Anspruch 1 oder 2,

dadurch gekennzeichnet, daß er im wesentlichen unter Anwendung von MOS-Technologie hergestellt ist.

5. IPLL nach Anspruch 1,
dadurch gekennzeichnet, daß die Filtereinrichtung ein geschaltetes Kapazitätsfilter (SCF) und eine Integratoreinrichtung aufweist.

6. IPLL nach Anspruch 1,
dadurch gekennzeichnet, daß die Eicheinrichtung wenigstens einen Digital/Analog-Umsetzer (M9-M12-MGn, M7-M8-M13-MBn; MDAC) aufweist, und daß weiterhin die Charakteristik der VCO über den Betriebsfrequenzbereich des IPLL bestimmt ist.

7. IPLL nach einem der Ansprüche 1 - 6,
dadurch gekennzeichnet, daß die Eicheinrichtung einen Digital/Analog-Umsetzer (M9-M12-MGn) aufweist, der in der Lage ist, den Abfall bzw. die Verstärkung der Eicheinrichtung einzustellen.

8. IPLL nach einem der Ansprüche 1 - 7,
dadurch gekennzeichnet, daß die Eicheinrichtung einen Digital/Analog-Umsetzer (M7-M8-M13-MBn) aufweist, und in der Lage ist, die Vorspannung der Eicheinrichtung einzustellen.

9. IPLL nach einem der Ansprüche 6 oder 7,
dadurch gekennzeichnet, daß die Eicheinrichtung weiterhin ein Register aufweist, das in der Lage ist, das zweite Bezugssignal mit einer Konstanten zu multiplizieren.

10. IPLL nach Anspruch 1,
dadurch gekennzeichnet, daß Kondensator/Schalt-Paare vorgesehen sind, die den VCO zugeordnet sind, um die Charakteristik der VCO zu beeinflussen.

11. IPLL nach Anspruch 1,
gekennzeichnet durch
Zähler- oder Teilereinrichtungen (COUNTER), die in der Lage sind, das digitale Signal zu empfangen und den Filtereinrichtungen ein geteiltes oder multipliziertes Taktsignal zuzuführen, wobei der IPLL von dem VCO ein multipliziertes Frequenzausgangssignal abgibt.

12. IPLL nach Anspruch 1,
dadurch gekennzeichnet, daß er zum Betrieb bei niedrigen oder mittleren Frequenzen geeignet ist.

13. IPLL nach Anspruch 1,
dadurch gekennzeichnet, daß das Ausgangssignal im wesentlichen spektralrein und daher eine Einzelfrequenz ist.

**Revendications**

1. Circuit à boucle à verrouillage de phase intégrable (IPLL) comprenant :
des moyens de filtrage de données échantillonnées qui échantillonnent un signal de référence pour fournir un signal de contrôle à la sortie ; et des moyens oscillateurs contrôlés de voltage ou de courant (VCO) qui comprennent une entrée de contrôle alimentée par la sortie des moyens de filtrage, la fréquence d'oscillation étant régulée par le signal de contrôle, et qui fournissent un signal digital de sortie qui alimente en retour les moyens de filtrage pour fournir un signal d'horloge pour l'échantillonnage ;
caractérisé par des moyens de calibration couplant la sortie des moyens de filtrage à l'entrée de contrôle du VCO et comprenant des moyens de gain et/ou de polarisation ajustables pouvant être réglés pour déterminer la caractéristique générale du signal contrôle à fréquence de l'IPLL indépendamment du paramètre du signal contrôle à fréquence du VCO.

2. IPLL selon la revendication 1, dans lequel les moyens de filtrage échantillonnent le signal de référence stroboscopiquement.

3. IPLL selon la revendication 1 ou 2, en ce qu'il est essentiellement intégrable totalement.

4. IPLL selon la revendication 1 ou 2, en ce qu'il est fabriqué en utilisant essentiellement une technologie MOS.

5. IPLL selon la revendication 1, dans lequel les moyens de filtrage comprennent un filtre à condensateur commutable (SCF) et des moyens d'intégration.

6. IPLL selon la revendication 1, dans lequel les moyens de calibration comprennent au moins un convertisseur digital analogique (M9-M12-MGn, M7-M8-M13-MBn ; MDAC) et où en outre la caractéristique du VCO est déterminée sur toute la gamme de fréquence de fonctionnement de l'IPLL.

7. IPLL selon l'une des revendications 1 à 6, dans lequel les moyens de calibration comprennent un convertisseur digital analogique (M9-M12-MGn) conçu pour régler la pente ou le gain du calibrateur.

8. IPLL selon l'une des revendications 1 à 7, dans lequel les moyens de calibration comprennent un convertisseur digital analogique (M7-M8-M13-MBn) conçu pour régler la polarisation du calibrateur.

9. IPLL selon l'une des revendications 6 ou 7, dans lequel les moyens de calibration comprennent un registre conçu pour multiplier par une constante le deuxième signal de référence.

10. IPLL selon la revendication 1, dans lequel on trouve des paires condensateur/interrupteurs en association avec le VCO afin d'influencer les caractéristiques du VCO.

11. IPLL selon la revendication 1, comprenant encore des moyens de comptage ou de division (COMPTEUR) conçus pour recevoir le signal digital et fournir aux moyens de filtrage un signal d'horloge divisé ou multiplié, l'IPLL fournissant à partir du VCO une sortie de fréquence multipliée.

12. IPLL selon la revendication 1, en ce qu'il est conçu pour fonctionner à des fréquences basses ou modérées.

13. IPLL selon la revendication 1, dans lequel le signal de sortie est essentiellement pur spectralement et en conséquence à fréquence unique.

Ref. In

PHASE DETECTOR

LOW-PASS FILTER

COUNTER (optional)

V.C.O

(Multiplied) FREQ. OUT

Control Volts F.M. Demod Out

FIGURE.1    PHASE-LOCKED LOOP (PRIOR ART)

REF. IN

SAMPLED DATA-FILTER

CONTROL-VOLTS OUT

CALIBRATOR

CLK

COUNTER (OPTIONAL)

V.C.O

(MULTIPLIED) FREQ. OUT

FIGURE.2   PHASE-LOCKED LOOP

CONTROL VOLTS

REF. IN

S1    C1   GND    S2    C2   GND    S3    C3   GND

CLK

FIGURE.3    SAMPLED DATA FILTER

FIGURE.4   VCO

NOTE: D1,D2 MAY BE
      MULTIPLYING DAC'S

CONTROL VOLTAGE
= FILTER OUTPUT

SET GAIN → D2 ▷ 12

I=I1-I2
VCO
CONTROL
CURRENT

FIXED OR CONSTANT
BIAS CURRENT

SET BIAS → D1 ▷ I1

FIGURE.5.  VCO CALIBRATION

VOLTAGE/CURRENT (- GAIN CONTROL BITS-)   OUTPUT CURRENT
CONVERTER                                MIRROR

¹M9   ²M12   ⁿMGn  MIO  MII  Vdd

M3   M4 M5  CONTROLLED
            OUTPUT    CIRCUIT 'D1'   I2

CONTROL VOLTS         FIXED BIAS
(FILTER OUTPUT)       CURRENT

M2   M6   CIRCUIT 'D2'   I1   I=I2-I1

M1

VCO CONTROL
CURRENT

Vss

M7   M8   MI3   MBn

(-BIAS CONTROL BITS-)

FIGURE.6.  CALIBRATOR

12

FIGURE.7  VCO  CALIBRATION

FIGURE.8  CALIBRATION TIMING.

FIGURE.9 . LINEAR VOLTAGE TO CURRENT CONVERTER (LVIC)